# EUROPEAN PATENT APPLICATION

(11) **EP 4 769 980 A1**
(43) Date of publication of application: **01.07.2026**
(21) Application number: 25226790.1
(22) Date of filing: 23.12.2025
(51) Int. Cl.: H04B 17/10, H04B 17/12, H04B 17/16, H04B 17/17

(54) **PORTABLE SYSTEM FOR ANTENNA MEASUREMENT AND/OR CALIBRATION**

(30) Priority: 26.12.2024 IL 31804224
(71) Applicant: Elta Systems Ltd., 7710201 Ashdod (IL)
(72) Inventor: NISSAN, Kobi, 7525869 Rishon LeZion (IL)
(74) Representative: Weickmann & Weickmann PartmbB

(57) **Abstract**

An antenna measurement system comprising tracks which typically removably engage e.g. clip onto the antenna, e.g. along at least one axis thereof; a probe which moves along the tracks; and software which derives calibration data characterizing the antenna using the probe, wherein, as the probe moves, the probe covers the antenna's entire surface.

## Description

### FIELD OF THIS DISCLOSURE

The present invention relates to antennae generally, and more particularly to near field measurements of phased array antennae inter alia.

### BACKGROUND FOR THIS DISCLOSURE

Outdoor ranges for antenna measurements exist e.g. as described in this online publication:
Https://www.ece.mcmaster.ca/faculty/nikolova/antenna_dload/current_lectures/L08_Measur e.pdf

Other known antenna calibration systems are described in the following published patent documents:
1. US8410987(B2) - Method and device for measuring a radiation field https://patents.google.com/patent/US8410987B2/en?oq=US8410987
2. US10148366(B2) - Calibration systems and methods https://patents.google.com/patent/US10148366B2/en?oq=US10148366(B2)
3. US4453164(A) - Method of determining excitation of individual elements of a phase array antenna from near-field data
   https://patents.google.com/patent/US4453164A/en?og=US4453164(A)
4. US10439280(B1) - Antenna measurement system and antenna measurement method https://patents.google.com/patent/US10439280B1/en?oq=US10439280(B1)
5. US10382076(B2) - Antenna device and measurement method https://patents.google.com/patent/US10382076B2/en?oq=5.US10382076(B2)+
6. CN109541330(A) - Array antenna channel calibration system for plane wave simulator https://patents.google.com/patent/CN109541330A/en?oq=CN109541330(A)+

The disclosures of all publications and patent documents mentioned in the specification, and of the publications and patent documents cited therein directly or indirectly, are hereby incorporated by reference, other than subject matter disclaimers or disavowals. If the incorporated material is inconsistent with the express disclosure herein, the interpretation is that the express disclosure herein describes certain embodiments, whereas the incorporated material describes other embodiments. Definition/s within the incorporated material may be regarded as one possible definition for the term/s in question.

Materiality of such publications and patent documents to patentability is not conceded.

### SUMMARY OF CERTAIN EMBODIMENTS

Certain embodiments of the present invention seek to provide circuitry typically comprising at least one processor in communication with at least one memory, with instructions stored in such memory executed by the processor to provide functionalities which are described herein in detail.

Any functionality described herein may be firmware-implemented or processor-implemented, as appropriate.

There is thus provided, in accordance with at least one embodiment of the present invention, an antenna near field measurements system comprising:
tracks which typically removably engage e.g. clip onto the antenna, e.g. along at least one axis thereof;
a probe which moves along the tracks; and/or
software which derives calibration data and/or antenna characteristics from the probe's output measurements.

In addition to the above features, the system according to this aspect of the presently disclosed subject matter can comprise one or more of features (i) to (xii) listed below, in any desired combination or permutation which is technically possible:
(i) wherein the probe moves along at least two axes.
(ii) wherein the probe moves along three axes.
(iii) wherein the probe measurements comprises a calibration ratio and/or characteristics of the antenna.
(iv) wherein the tracks comprise plural track segments of a single length to enable the system to accommodate antennas which have different lengths by selecting an appropriate number of the plural track segments to equal or exceed a length of each antenna which the system seeks to calibrate.
(v) wherein the probe is controlled by a controller to move along the tracks to cover an entire surface of any antenna sought to be calibrated.
(vi) also comprising an antenna to be calibrated, wherein the antenna comprises a phased array antenna.
(vii) wherein the antenna comprises a component in a radar system.
(viii) wherein the probe which moves along the track comprises any one of plural probes having respective plural frequencies, thereby facilitating near field measurements of plural antennas, each having a different frequency.
(ix) wherein all components of the system are portable.
(x) wherein the tracks are deployed along at least one of two main axes defined by the antenna's main surface.
(xi) wherein the plural track segments comprise plural identical track components, each of which typically removably engages the antenna.
(xii) wherein the antenna to be measured has a side-facing main surface, and wherein the tracks are deployed along the antenna's top surface, thereby scanning a horizontal main axis x defined by the antenna's main surface, and wherein a pole is deployed alongside the antenna's side surface, and the probe translates along the pole, thereby to scan the vertical main axis y defined by the antenna's main surface.
According to another aspect of the presently disclosed subject matter there is provided an antenna near field measurements method comprising:
providing tracks which typically removably engage e.g. clip onto the antenna;
moving a probe along the tracks; and
providing software which derives calibration data characterizing the antenna using the probe, wherein, as the probe moves, the probe covers the antenna's entire surface.

This aspect of the disclosed subject matter can comprise one or more of features (i) to (vii) listed above with respect to the system, *mutatis mutandis,* in any desired combination or permutation which is technically possible.

In addition to the above features, the system according to this aspect of the presently disclosed subject matter can comprise one or more of features (i) to (vi) listed below, in any desired combination or permutation which is technically possible:
(i) wherein the antenna is outdoors, and need not be inside an indoor range.
(ii) wherein the antenna to be measured is an operating antenna remote from a facility responsible for near field measurements , and wherein the antenna is measured *in situ* without being brought to the facility.
(iii) wherein the probe measurements is used for fault finding.
(iv) wherein the probe measurements comprises near field measurements
(v) wherein the probe measurements comprises at least one calibration ratio.
(vi) wherein the plural track segments each comprise a profile having a uniform cross section.

This aspect of the disclosed subject matter can comprise one or more of features (i) to (xii) listed above with respect to the system, *mutatis mutandis,* in any desired combination or permutation which is technically possible.

Certain embodiments provide a portable range (e.g. test range) for antenna measurement which may be mounted on an antenna which typically includes a matrix or array of antenna elements such as a phased array antenna.

Certain embodiments provide an outdoor range for antenna measurement with an MCS (mobile calibration system) which measures the antenna from a very close range, e.g., the probe can measure when distanced a few centimeters from, or less, or 1 meter or more from the antenna plane.

Certain embodiments of the present invention seek to provide a portable system for measuring an antenna's calibration ratio and antenna characteristics outdoors and/or without using an indoor range, which can, for example, be used for testing antennae in the field and/or for fault-finding.

Certain embodiments provide an outdoor range for antenna measurement having a signal processor with advanced algorithms that determine whether to eliminate interference, e.g. analytically, or whether to measure again if the measurement is found not to be satisfactory. Any suitable processes
to eliminate interference analytically, typically implemented in software, may be employed e.g. Spectral Efficiency Optimization, and special techniques such as frequency hopping and phase changing can be used to minimize interference. Alternatively, or in addition, any other algorithm/s may be employed.

Certain embodiments of the present invention seek to provide an antenna measurement system which is portable and/or can be used outdoors and *en situ* and/or accommodates or supports plural antennae having plural dimensions respectively, i.e. of different sizes, and/or supports plural antennae having plural frequencies respectively i.e. using different frequencies and/or which is mounted on the antennae to be measured and/or is otherwise "scalable" (being typically designed to measure plural sizes and/or frequencies of phased array antenna e.g. by accommodating plural different antennae and/or provides a set of interchangeable probes each of which is configured to measure a given frequency) and/or is mounted on the antenna and/or moves along (typically all three) axes of the antennae e.g. the antennae's x and y axes (which define the antenna's main plane) and the antenna's z-axis.

It is appreciated that example implementations of each of the above characteristics are described in detail herein.

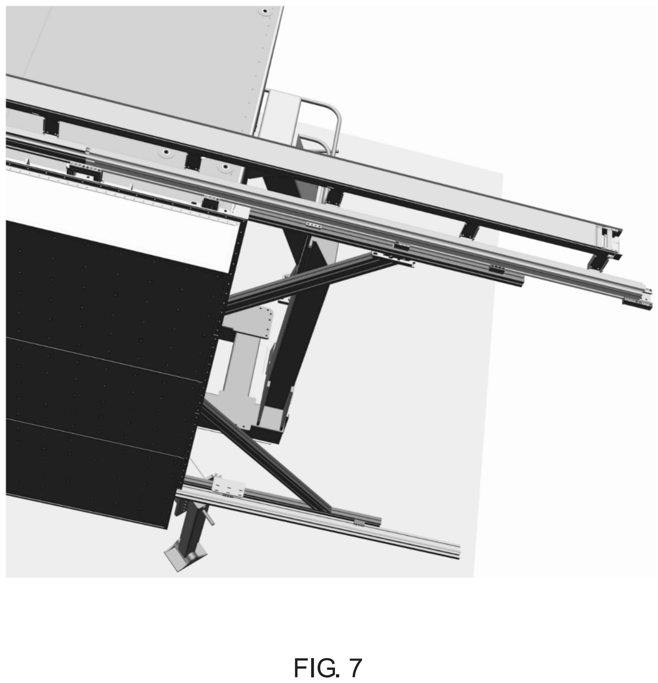

To accommodate different sizes of antenna, e.g. different lengths of the antenna along the y-axis, the tracks may be formed of typically equally sized track-portions or segments, e.g. as shown in Fig. 7. If, for example, each track-portion or segment is three meters long, then for an antenna whose x-axis is 10 meters, four such track portions may be employed.

According to certain embodiments, the system checks the quality of measurement using any suitable quality parameter, such as but not limited to all or any subset of the following:
1. Signal power
2. SNR (signal-to-noise ratio)
3. Interference

The system then typically re-measures the antenna if quality, as measured, is below the threshold.

Also provided is a computer program product, comprising a non-transitory tangible computer readable medium having computer readable program code embodied therein, the computer readable program code adapted to be executed to implement an antenna near field measurements method comprising providing tracks which typically removably engage e.g. clip onto the antenna; and/or moving a probe along the tracks; and/or providing software which derives calibration data characterizing the antenna using the probe, wherein, as the probe moves, the probe covers the antenna's entire surface.

Also provided, excluding signals, is a computer program comprising computer program code means for performing any of the methods shown and described herein when the program is run on at least one computer; and a computer program product, comprising a typically non-transitory computer-usable or -readable medium e.g. non-transitory computer - usable or -readable storage medium, typically tangible, having a computer readable program code embodied therein, the computer readable program code adapted to be executed to implement any or all of the methods shown and described herein. The operations in accordance with the teachings herein may be performed by at least one computer specially constructed for the desired purposes. or a general-purpose computer specially configured for the desired purpose by at least one computer program stored in a typically non-transitory computer-readable storage medium. The term "non-transitory" is used herein to exclude transitory, propagating signals or waves, but to otherwise include any volatile or non-volatile computer memory technology suitable to the application.

Any suitable processor/s, display and input means may be used to process, display e.g. on a computer screen or other computer output device, store, and accept information such as information used by or generated by any of the methods and apparatus shown and described herein; the above processor/s, display and input means including computer programs, in accordance with all or any subset of the embodiments of the present invention. Any or all functionalities of the invention shown and described herein, such as but not limited to operations within flowcharts, may be performed by any one or more of at least one conventional personal computer processor, workstation or other programmable device or computer or electronic computing device or processor, either general-purpose or specifically constructed, used for processing; a computer display screen and/or printer and/or speaker for displaying; machine-readable memory such as flash drives, optical disks, CDROMs, DVDs, BluRays, magnetic-optical discs or other discs; RAMs, ROMs, EPROMs, EEPROMs, magnetic or optical or other cards, for storing, and keyboard or mouse for accepting. Modules illustrated and described herein may include any one or combination or plurality of a server, a data processor, a memory/computer storage, a communication interface (wireless (e.g. BLE) or wired (e.g. USB)), and a computer program stored in memory/computer storage.

The term "process" as used above is intended to include any type of computation or manipulation or transformation of data represented as physical, e.g. electronic, phenomena which may occur or reside e.g. within registers and /or memories of at least one computer or processor. Use of nouns in singular form is not intended to be limiting; thus, the term processor is intended to include a plurality of processing units which may be distributed or remote, the term server is intended to include plural typically interconnected modules running on plural respective servers, and so forth.

The above devices may communicate via any conventional wired or wireless digital communication means, e.g. via a wired or cellular telephone network or a computer network such as the Internet.

The apparatus of the present invention may include, according to certain embodiments of the invention, machine readable memory containing or otherwise storing a program of instructions which, when executed by the machine, implements all or any subset of the apparatus, methods, features, and functionalities of the invention shown and described herein. Alternatively, or in addition, the apparatus of the present invention may include, according to certain embodiments of the invention, a program as above which may be written in any conventional programming language, and optionally a machine for executing the program, such as but not limited to a general-purpose computer which may optionally be configured or activated in accordance with the teachings of the present invention. Any of the teachings incorporated herein may, wherever suitable, operate on signals representative of physical objects or substances.

The embodiments referred to above, and other embodiments, are described in detail in the next section.

Any trademark occurring in the text or drawings is the property of its owner and occurs herein merely to explain or illustrate one example of how an embodiment of the invention may be implemented.

Unless stated otherwise, terms such as, "processing", "computing", "estimating", "selecting", "ranking", "grading", "calculating", "determining", "generating", "reassessing", "classifying", "generating", "producing", "stereo-matching", "registering", "detecting", "associating", "superimposing", "obtaining", "providing", "accessing", "setting" or the like, refer to the actions and/or processes of at least one computer/s or computing system/s, or processor/s or similar electronic computing device/s or circuitry, that manipulate and/or transform data which may be represented as physical, such as electronic, quantities e.g. within the computing system's registers and/or memories, and/or may be provided on-the-fly, into other data which may be similarly represented as physical quantities within the computing system's memories, registers, or other such information storage, transmission or display devices, or may be provided to external factors, e.g. via a suitable data network. The term "computer" should be broadly construed to cover any kind of electronic device with data processing capabilities, including, by way of non-limiting example, personal computers, servers, embedded cores, computing system, communication devices, processors (e.g. digital signal processor (DSP), microcontrollers, field programmable gate array (FPGA), application specific integrated circuit (ASIC), etc.) and other electronic computing devices. Any reference to a computer, controller, or processor is intended to include one or more hardware devices e.g. chips, which may be co-located or remote from one another. Any controller or processor may, for example, comprise at least one CPU, DSP, FPGA or ASIC, suitably configured in accordance with the logic and functionalities described herein.

Any feature or logic or functionality described herein may be implemented by processor/s or controller/s configured as per the described feature or logic or functionality, even if the processor/s or controller/s are not specifically illustrated for simplicity. The controller or processor may be implemented in hardware, e.g., using one or more Application-Specific Integrated Circuits (ASICs) or Field-Programmable Gate Arrays (FPGAs), or may comprise a microprocessor that runs suitable software, or a combination of hardware and software elements.

The present invention may be described, merely for clarity, in terms of terminology specific to, or references to, particular programming languages, operating systems, browsers, system versions, individual products, protocols and the like. It will be appreciated that this terminology or such reference/s is intended to convey general principles of operation clearly and briefly, by way of example, and is not intended to limit the scope of the invention solely to a particular programming language, operating system, browser, system version, or individual product or protocol. Nonetheless, the disclosure of the standard or other professional literature defining the programming language, operating system, browser, system version, or individual product or protocol in question, is incorporated by reference herein in its entirety.

Elements separately listed herein need not be distinct components, and alternatively may be the same structure. A statement that an element or feature may exist is intended to include (a) embodiments in which the element or feature exists; (b) embodiments in which the element or feature does not exist; and (c) embodiments in which the element or feature exist selectably, e.g. a user may configure or select whether the element or feature does or does not exist.

Any suitable input device, such as but not limited to a sensor, may be used to generate or otherwise provide information received by the apparatus and methods shown and described herein. Any suitable output, device, or display may be used to display or output information generated by the apparatus and methods shown and described herein. Any suitable processor/s may be employed to compute or generate or route, or otherwise manipulate or process information as described herein and/or to perform functionalities described herein and/or to implement any engine, interface, or other system illustrated or described herein. Any suitable computerized data storage e.g. computer memory may be used to store information received by or generated by the systems shown and described herein. Functionalities shown and described herein may be divided between a server computer and a plurality of client computers. These or any other computerized components shown and described herein may communicate between themselves via a suitable computer network.

The system shown and described herein may include a user interface which may, for example, include all or any subset of: an interactive voice response interface, automated response tool, speech-to-text transcription system, automated digital or electronic interface having interactive visual components, web portal, visual interface loaded as web page/s or screen/s from server/s via communication network/s to a web browser or other application downloaded onto a user's device, automated speech-to-text conversion tool, including a front-end interface portion thereof and back-end logic interacting therewith. Thus, the term user interface or "UI" as used herein includes also the underlying logic which controls the data presented to the user e.g. by the system display and receives and processes data entered by a user e.g. using her or his workstation/device.

### BRIEF DESCRIPTION

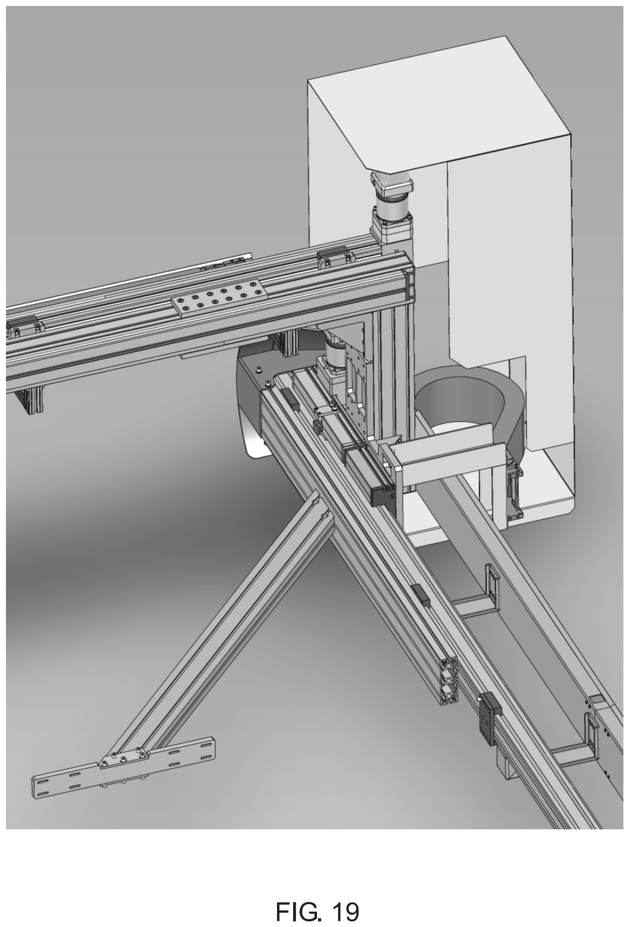

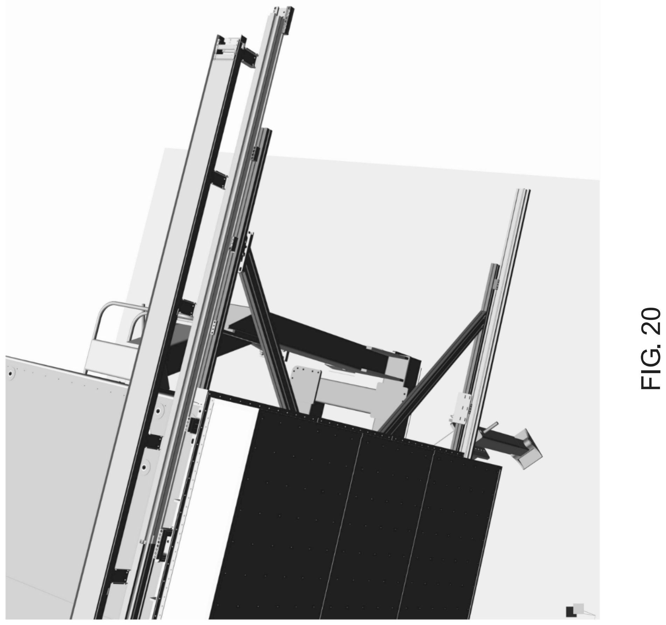

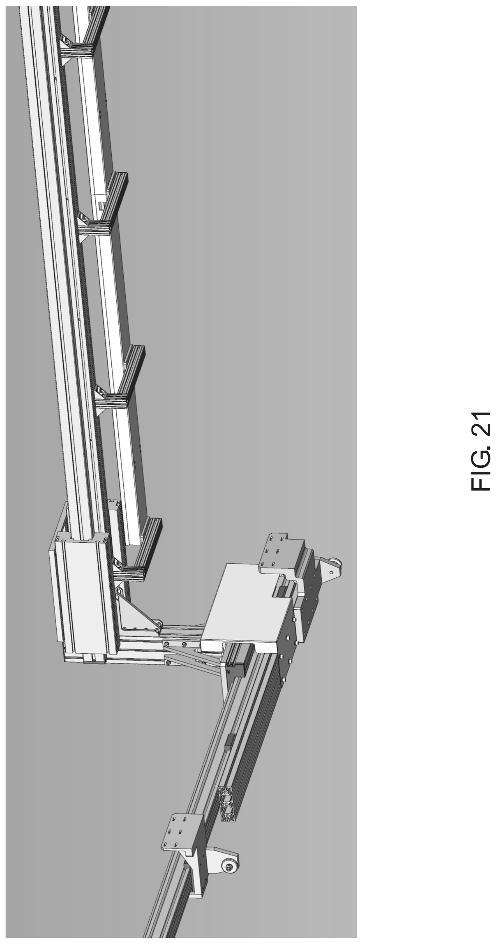

Figs. 1-3, and 6-20 illustrate various views and portions of an MCS, aka mobile calibration system, constructed and operative in accordance with certain embodiments.

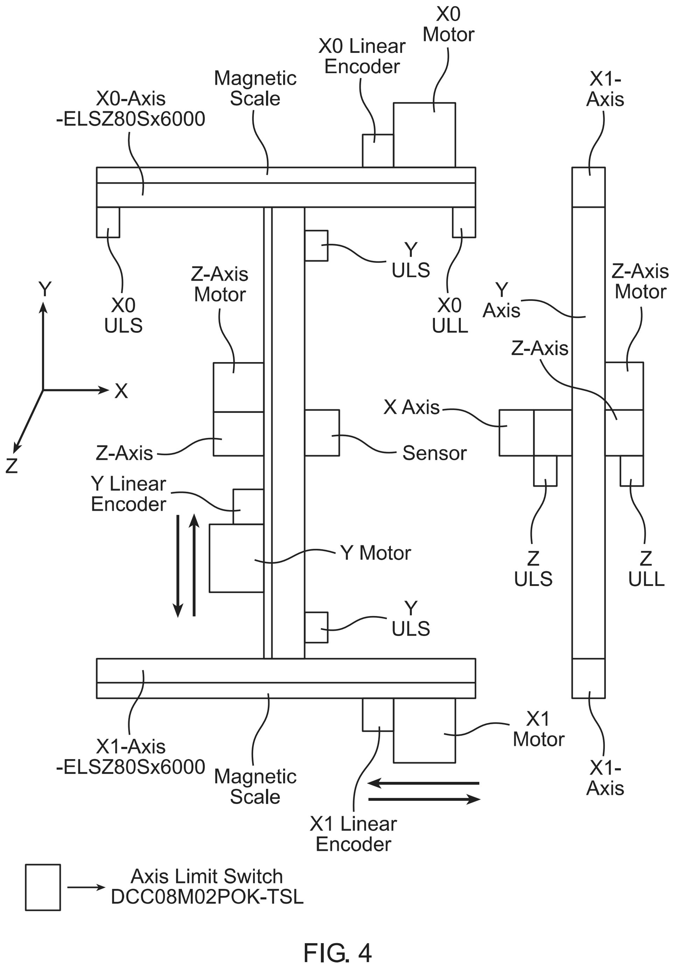

Fig. 4 is a simplified block diagram depicting the entirety of an example mobile calibration system so as to capture various elements of the system in a single drawing, although they may not be visible from any given view.
Figure 5 is a simplified flow chart illustration of a method according to certain embodiments of the present invention wherein all or any subset of the illustrated operations may be performed
Fig. 22 shows an example distance of an example MCS adapter flange from an antenna.
Fig. 23 shows an example MCS interface point to an example measured antenna structure.
Fig. 24 shows an example MCS interface RIVNUT position.

It is appreciated that elements illustrated in more than one drawing, and/or elements in the written description, or even entire embodiments, may still be combined into a single embodiment, except if otherwise specifically clarified herewithin.

Methods and systems included in the scope of the present invention may include some (e.g. any suitable subset) or all of the functional blocks shown in the specifically illustrated implementations by way of example, in any suitable order e.g. as shown.

Computational, functional or logical components described and illustrated herein can be implemented in various forms, for example, as hardware circuits, such as but not limited to custom VLSI circuits or gate arrays, or programmable hardware devices, such as but not limited to FPGAs, or as software program code stored on at least one tangible or intangible computer-readable medium and executable by at least one processor, or any suitable combination thereof. A specific functional component may be formed by one particular sequence of software code, or by a plurality of such, which collectively act or behave or act as described herein with reference to the functional component in question. For example, the component may be distributed over several code sequences, such as but not limited to objects, procedures, functions, routines, and programs, and may originate from several computer files which typically operate synergistically.

Each functionality or method herein may be implemented in software (e.g. for execution on suitable processing hardware such as a microprocessor or digital signal processor), firmware, hardware (using any conventional hardware technology such as Integrated Circuit technology) or any combination thereof.

Functionality or operations stipulated as being software-implemented may alternatively be wholly or fully implemented by an equivalent hardware or firmware module, and vice-versa. Firmware implementing functionality described herein, if provided, may be held in any suitable memory device and a suitable processing unit (aka processor) may be configured for executing firmware code. Alternatively, certain embodiments described herein may be implemented partly or exclusively in hardware, in which case all or any subset of the variables, parameters, and computations described herein may be in hardware.

Any module or functionality described herein may comprise a suitably configured hardware component or circuitry. Alternatively, or in addition, modules or functionality described herein may be performed by a general-purpose computer, or more generally by a suitable microprocessor, configured in accordance with methods shown and described herein, or any suitable subset, in any suitable order, of the operations included in such methods, or in accordance with methods known in the art.

Any logical functionality described herein may be implemented as a real time application, if and as appropriate, and which may employ any suitable architectural option, such as but not limited to FPGA, ASIC, or DSP, or any suitable combination thereof.

Any hardware component mentioned herein may in fact include either one or more hardware devices e.g. chips, which may be co-located or remote from one another.

Any method described herein is intended to include within the scope of the embodiments of the present invention also any software or computer program performing all or any subset of the method's operations, including a mobile application, platform, or operating system e.g. as stored in a medium, as well as combining the computer program with a hardware device to perform all or any subset of the operations of the method.

Data can be stored on one or more tangible or intangible computer-readable media stored at one or more different locations, different network nodes, or different storage devices at a single node or location.

It is appreciated that any computer data storage technology, including any type of storage or memory and any type of computer components and recording media that retain digital data used for computing for an interval of time, and any type of information retention technology, may be used to store the various data provided and employed herein. Suitable computer data storage or information retention apparatus may include apparatus which is primary, secondary, tertiary or off-line; which is of any type or level or amount or category of volatility, differentiation, mutability, accessibility, addressability, capacity, performance and energy use; and which is based on any suitable technologies such as semiconductor, magnetic, optical, paper, and others.

### DETAILED DESCRIPTION

The Near field measurements process is standard practice in the industry to ensure that antennas meet the performance expectations for specified use cases. Near field measurements ensures that the antenna performs according to its specified characteristics, such as radiation pattern, gain, impedance, and frequency response.

All antenna manufacturers generally measure the antennas they produce, but the extent and type of measurements can vary, depending on the type of antenna and its intended application. High-performance antennas and/or phased array antennae, like those used in air surveillance and/or air defence radar and/or critical communications and/or other specialized fields, including but not limited to military use, undergo more extensive measurements , e.g. including lab testing, field testing, and sometimes individual unit calibration.

Before antennas are shipped, manufacturers often test them in controlled environments to verify that their design specifications are met. This testing ensures that the antenna will perform optimally for its intended purpose.

Near field measurements often includes measuring the antenna's radiation pattern to ensure that it emits or receives signals in the expected directions and with the intended strength. This is especially important for antennas designed for specific frequency bands to ensure minimal signal loss and optimal power transfer.

The gain of the antenna and its radiation pattern may be crucial factors. Manufacturers often use anechoic chambers (special rooms designed to prevent any reflection of radio waves) to measure these parameters accurately.

The gain and radiation pattern are typically measured over a range of frequencies, and the antenna's performance is calibrated to make sure it works within the desired frequency range.

Antennas may be calibrated for the frequency bands they are designed for, whether for civilian or military purposes, as well as for satellite communications. This ensures that the antenna operates efficiently within the specified bandwidth.

Some manufacturers perform a final test on each antenna they produce, especially in high-precision or high-reliability applications (e.g., aerospace, military, medical). These tests help identify any manufacturing defects or variations.

In mass production, the level of measurements can vary, but, typically, a sample of units is tested and calibrated, ensuring the batch meets the overall design criteria.

Antenna near field measurements can be a bottleneck in the manufacturing and testing process:
Simple antennas (e.g., dipole, monopole, or basic patch antennas) may require less measuring time since their radiation patterns and other characteristics are less complex. Even for basic antennas, near field measurements might take anywhere from 30 minutes to a few hours, depending on the testing setup and the specific parameters being measured.

Complex antennas (e.g., phased arrays, multi-band antennas, or antennas with highly directive beams) require more sophisticated testing and measurements , which increases time. For more complex antennas, such as high-gain directional antennas or multi-band designs, near field measurements could take several hours to a full day and more commonly, plural days or even a few weeks depending e.g. on the antenna size.

Wideband and multi-frequency antennas may need to be measured and/or calibrated across a broader range of frequencies, extending the measuring time., especially phase array antennas, which may have a large number of radiate elements.

Some applications, like aerospace, military, or medical systems, require very precise performance specifications. For example, antennas used in air surveillance or air defense radar systems often have very tight gain and pattern requirements, which necessitate more detailed measurements . High-precision or custom antennas, such as those used in air surveillance or air defense radar systems, may require several days of testing or more, especially if they need to be calibrated for different environmental conditions or optimized across a wide frequency range.

Setting up these systems and measuring parameters like impedance, radiation pattern, gain, and frequency response, can take time, especially for complex or high-precision antennas.

The use of an anechoic chamber for measuring the radiation pattern and gain of antennas is standard for high-accuracy measurements . However, chamber testing can be time-consuming due to the need for precise alignment and multiple measurements across a range of angles and frequencies.

Testing an antenna's radiation pattern in multiple directions (azimuth, elevation) across a frequency band can take anywhere from a few hours to a full day to plural days, particularly for large antennas and/or depending on the antenna's complexity.

### Post- measurements :Adjustments:

After the initial measurements, adjustments may be made to the antenna design or manufacturing process. For instance, if an antenna's impedance does not match the target value, such as gain and or beam width, it may require physical modifications or tuning. These adjustments and retesting can prolong the measurements process.

### Batch vs. Individual measurements :

In mass production, manufacturers may not measure every antenna individually. Instead, they may perform a sample test of a small batch to ensure consistency with design specs. This can speed up the process, but still requires time to set up and test the sample units.

Custom or high-performance antennas (e.g., those used in military, satellite, or aerospace applications) might require full near field measurements for each individual unit, leading to longer measuring times.

There are various reasons why near field measurements can cause bottlenecks:
near field measurements requires specialized equipment and facilities (e.g., anechoic chambers, precision measuring instruments) which are costly and time-consuming to operate. Availability of these resources may limit the throughput of the measurements process.

Testing for Multiple Parameters: Modern antennas often need to be calibrated for multiple parameters (e.g., gain, radiation pattern, impedance, bandwidth), and each of these requires different measurement setups and configurations. This can contribute to longer measuring times.

Accuracy vs. Speed: Achieving high-accuracy results (e.g., ensuring very precise gain measurements or radiation patterns) can be time-consuming. Balancing speed with precision often becomes a trade-off. High-accuracy measurements may slow down the overall production process.

Production Constraints: In high-volume manufacturing, antennas must undergo measurements and testing to ensure consistency across large batches, which can be a logistical challenge. Testing a large number of units individually would be time-prohibitive, so manufacturers often need to balance quality control with speed.

near field measurements conventionally requires specialized equipment, often including anechoic chambers (rooms designed to measure antenna performance without interference from external signals), vector network analyzers (VNAs), and robotic antenna measurement systems that can rotate the antenna and measure its radiation pattern and gain.

In contrast, the MCS aka Mobile Calibration System according to embodiments herein, is typically portable and is typically scalable e.g., is typically designed to measure plural sizes and/or frequencies of phased array antenna.

The MCS, aka Mobile Calibration System, according to embodiments herein, typically comprises a portable antenna measurements system for measuring a calibration ratio and/or antenna characteristics without the use of a near field test range adapted to all frequency ranges. The device fits onto an existing antenna frame and mechanically scans all antenna elements, and with dedicated software performs measurements that are recorded. Then, from these measurements it is possible to produce a calibration ratio and extract antenna characteristics . The system can also be used to test the antenna in the field and to detect faults, thus meeting the need to measure an antenna and create a calibration ratio even outside the near field test range (chamber) which is a costly resource and causes bottlenecks. The system is low-cost and can significantly improve antenna measurement times and shorten delivery times to customers, which also results in very large cost savings. In addition, it can be used as a tool for testing and validating systems already in the field, instead of returning them to the range.

Technological advantages include all or any subset of:
- Shortening antenna measurement times and thus faster delivery to customers
- Possibility of testing and repairing systems that have already been delivered to customers abroad
- Shortening antenna measurement times, and thus faster delivery to customers
- Measuring antennas out of the test range chamber at the same time by several systems
- Inspection and repair of malfunctions in antennas that have already been delivered to customers.

It is appreciated that a near field test range is a costly resource that requires a special structure and is therefore a bottleneck in the process of supplying the antennas to customers.

The system is typically built from a central axis with the possibility of movement in three axes (x, y, z) which is controlled by software and can scan the entire surface of the antenna. In the center is a horn antenna or other antenna that transmits a signal. The position of the horn and the measurement of the signal is recorded and processed.

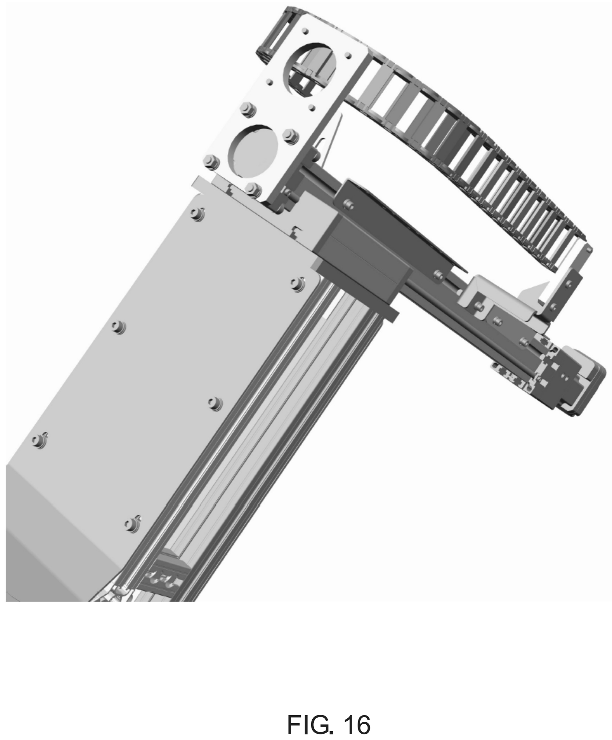

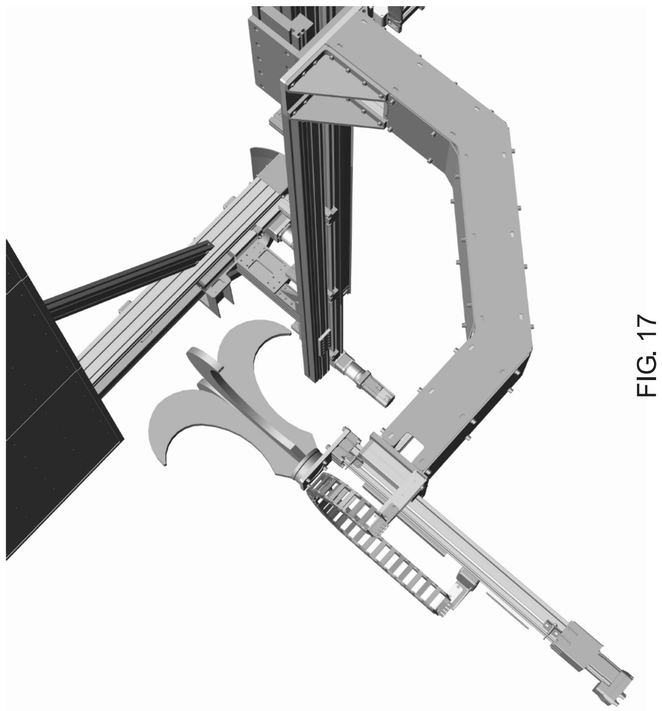

MCS scalability may include all or any of the following aspects:
a. Length of the tracks.
b. Different probe EG probes of different frequencies. Typically, the system software uses the frequency merely for near field to far field transformation, and for matching the recorded data to the frequency that was used in the measurements. For measuring the system software, it typically only needs to know the x, y, z axes. The hardware that produces the signal for measurement may be part of the antenna hardware and may be designed for the relevant frequency. For example, note that Fig. 16 shows an AZ axis pole with cable rails without a probe, thus the system herein is able to adapt to different probes. Compare this to Fig. 17 which shows the same, but this time with a probe which may be disconnected and replaced with another probe, such as a probe for a different frequency given an antenna of a different frequency which is to be calibrated.
c. Length of the main pole.

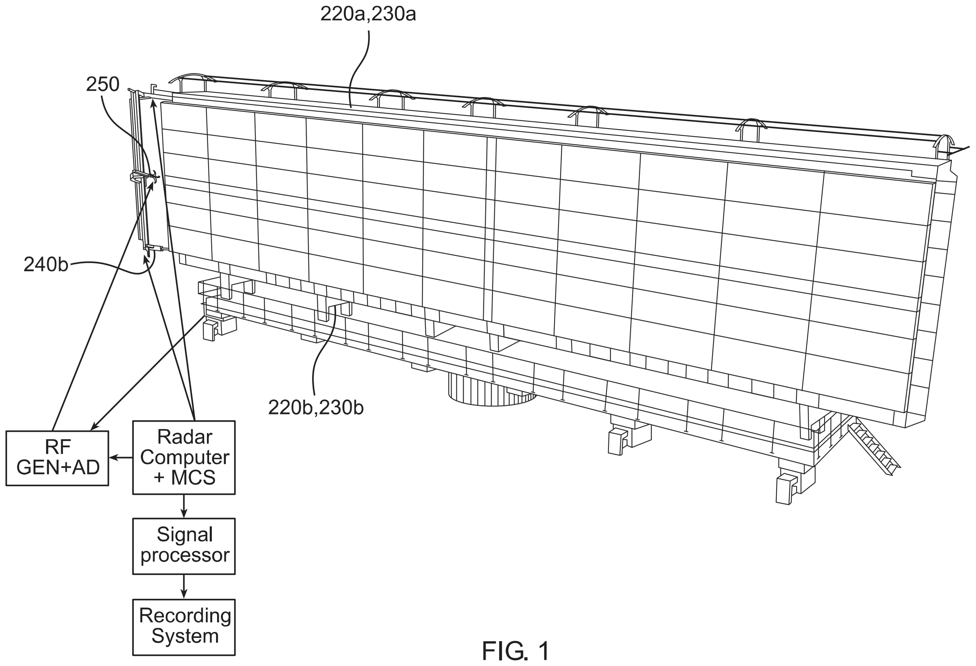

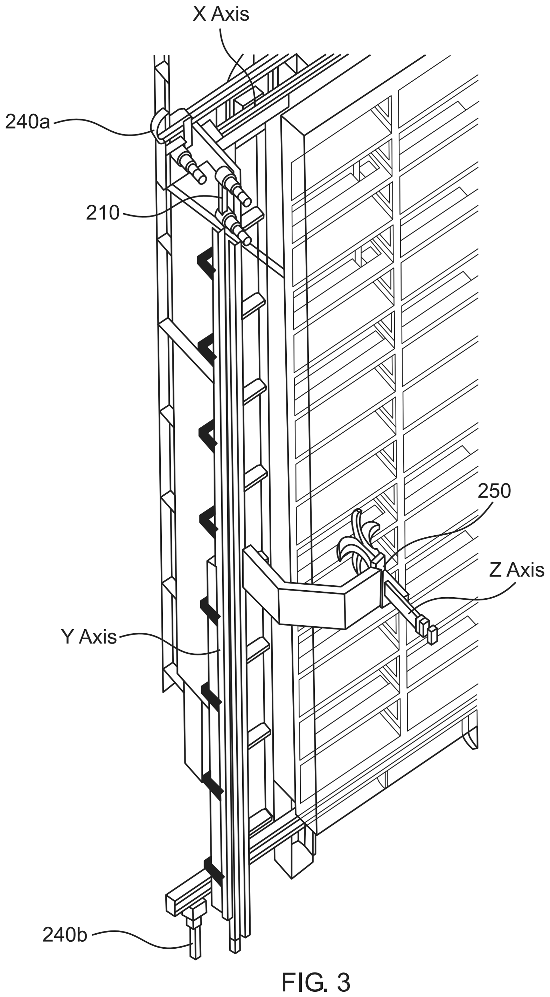

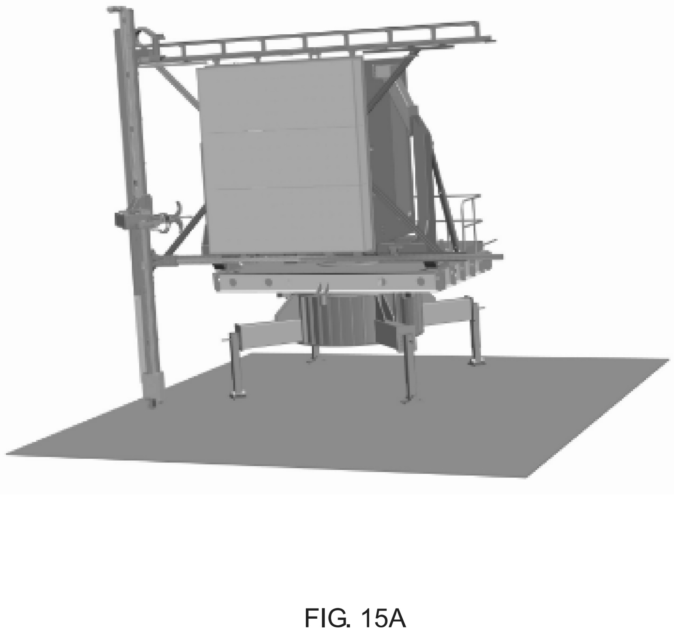

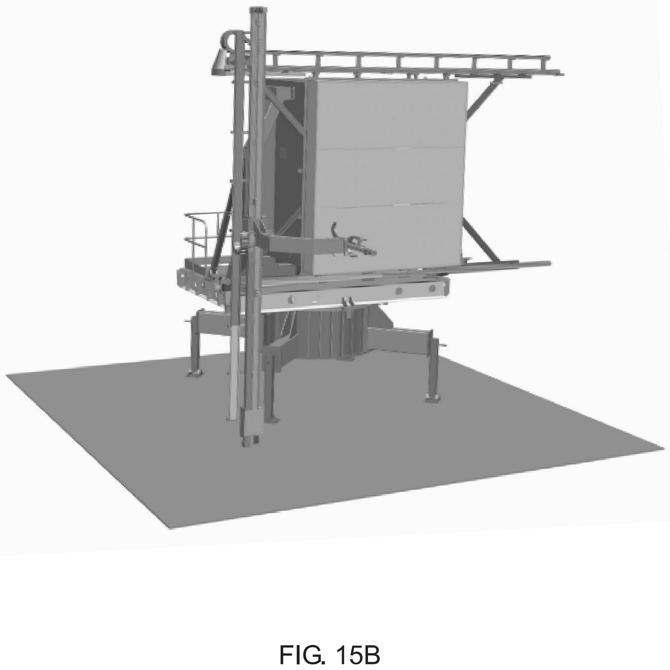

For example, Fig. 1 shows a probe of a large antenna, as does Fig. 3, whereas Figs. 15-A and 15-B show a probe on a smaller antenna which is accomplished by adapting the x and y rails to different sizes, thereby to achieve scalability.

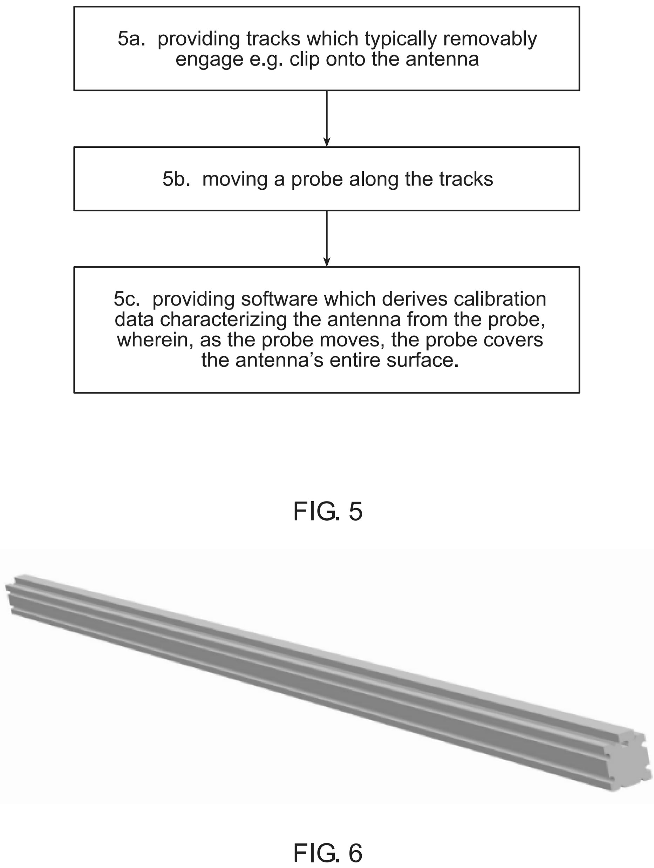

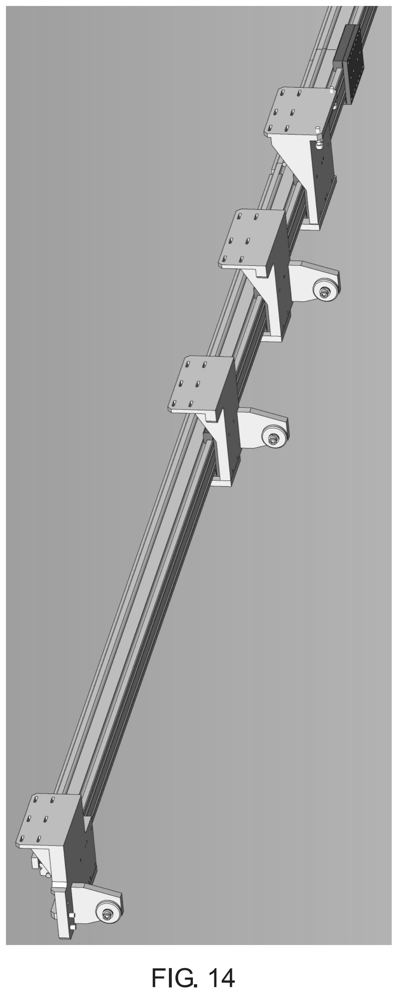

By using the x, y, z axes, e.g. as shown in Fig. 3, the measured probe can be adjusted to antennae of various sizes and frequencies. For example, consider a different antenna whose X axes are of different lengths. Fig. 14 is an adaptor aka rail adaptor that connects the track lying along the x-axis to the antenna: different adaptors can be provided, depending on the antenna being measured). Fig. 6 shows an example track segment for the x-axis rails or tracks.

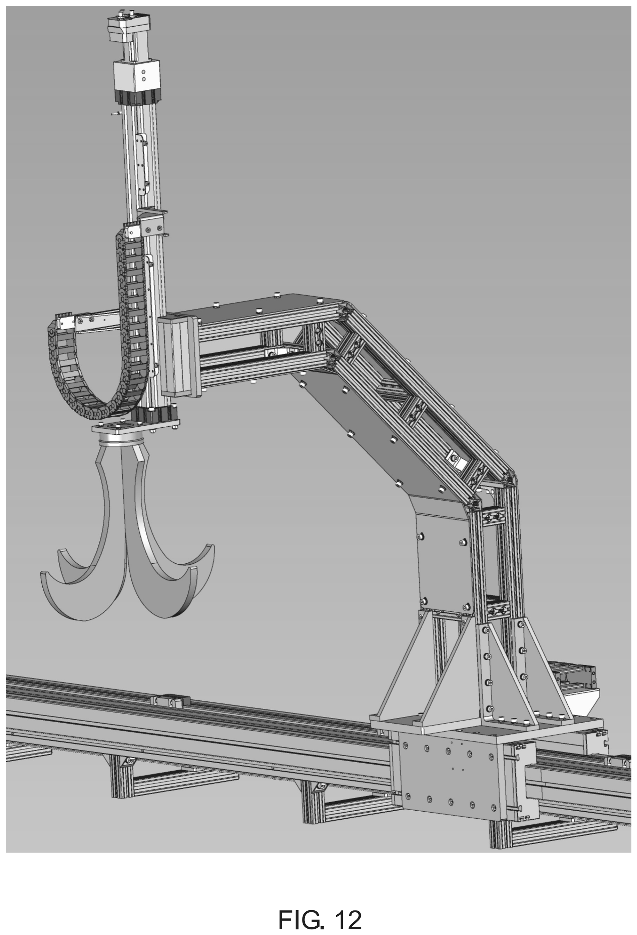

The y-axis may change, e.g. as shown in Fig. 15a, where the antenna aperture may be decreased or reduced and the effective length of the main probe pole along the y-axis may also be decreased. The z-axis motor an embodiment of which is seen in Fig. 7, together with an example probe in Fig.12 may comprise an electric motor that translates say up to half a meter in and out, and typically controls and can change position (distance) from the antenna surface.

The MCS main probe pole along the y-axis typically comprises a motorized main probe pole 210 that translates along and/or runs on two typically parallel rails or tracks 220a, 220b which may be added to the antenna in the upper and lower decks 230a, 230b respectively, of an antenna under test. Typically, the pole moves along the tracks that are mounted at top and or bottom of the antenna in the x-axis and on the pole in y and or z-axis. Fig. 3 shows the Y pole and an example probe with x axis, y axis, and g-axis motors.

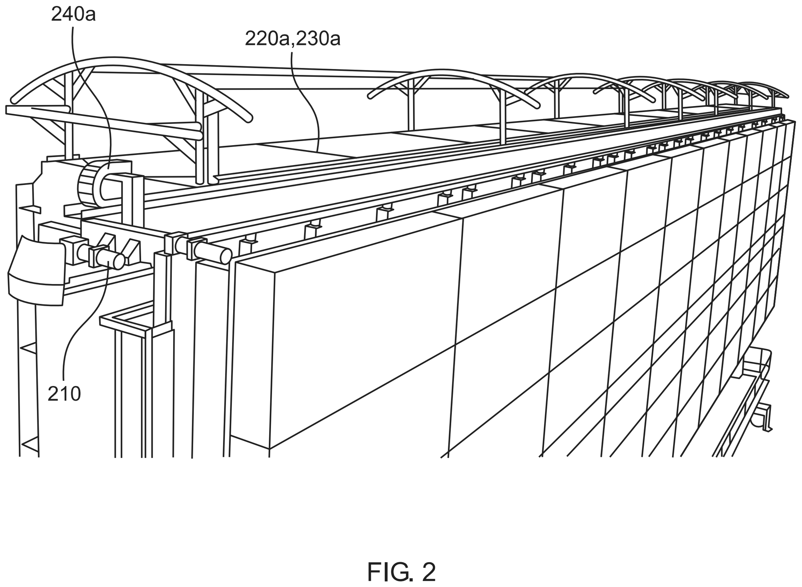

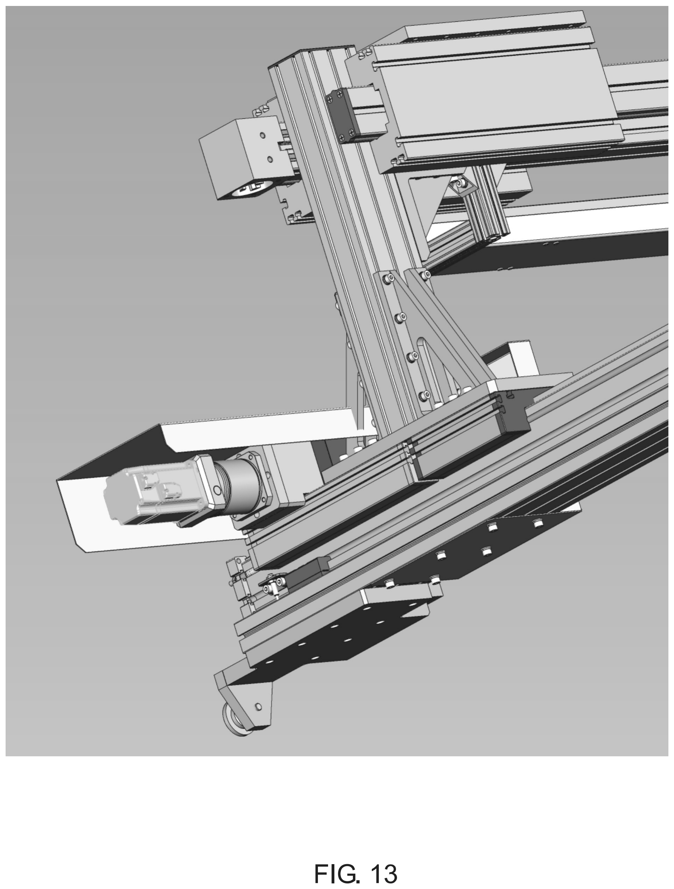

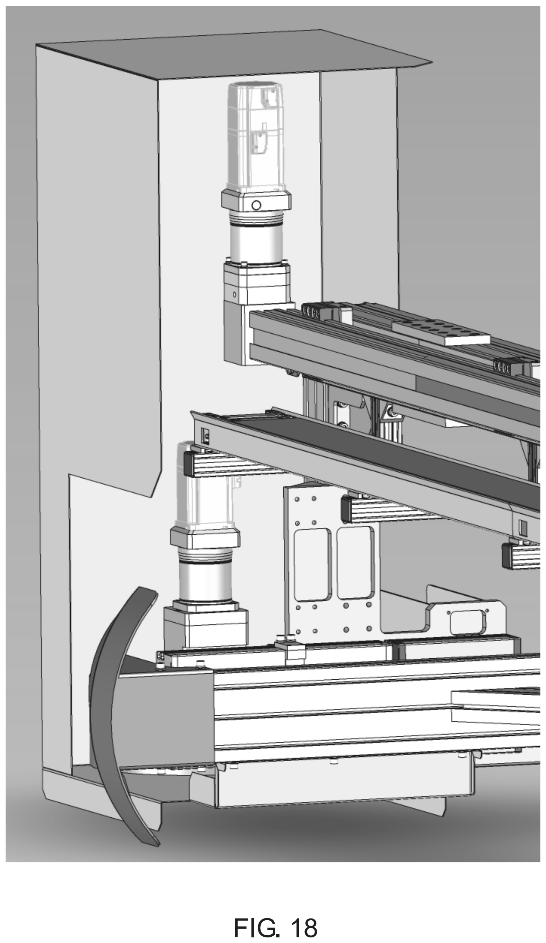

The pole 210 typically combines or is operatively associated with two x synchronized motors 240a and 240b, a y-motor 240c and a z-motor 250 allowing the probe to move in all x, y, z vectors aka x, y, z axes shown in Fig. 3. Thus, the main probe 210 can reach each point of the radiated surface 260 of the antenna under test. An example X motor is shown in Figs. 2 and 13. An example y motor is shown in Fig. 18.

The MCS typically includes dedicated software which may reside in any of the radar's computer/s and/or may reside in a dedicated main computer that controls the MCS. This software as described elsewhere herein typically controls movements of probe 210, and is also typically responsible for RF measurements by using the radar's main computer 270 (aka "radar computer" in Fig. 2) that controls the radar system (typically including control of radar hardware e.g. control of recording system shown in Fig. 2) and the radar's signal processor computer 280 in Fig. 2.

MCS software may reside in computers which are part of radars (or in a dedicated computer) to control all radar system computers. Typically, the radar's recording system is configured to record all data measurements made in, say, task1 and task2 described below.

Typically, the radar computer includes all the x,y position maps, e.g. x, y, z antenna elements position map/s and operates the radar RF signals and may also operate the MCS.

The MCS may perform two main tasks e.g. task1 - calibration ratio measurements (e.g. receive chain characteristics) and/or task2 - near field measurements.

The measurement procedure may include:
1. Close surface measurements and or
2. Near field measurements

Close surface measurements typically include loading the mechanical x, y position of each element (in the antenna x, y map e.g.).

It turns out that measurement of the antenna from very close range succeeds in eliminating some of the outdoor reflection and interference.

In near field measurements there is typically a need to achieve at least three times the wave length (for near field to far field transformation).

Antenna measurements may include all or any subset of the following:
**Calibration Ratio:** used e.g. to calibrate the antenna after RF unit replacement
**Radiation Pattern:** how the antenna radiates energy in different directions, for understanding coverage and directivity.
**Gain:** how effectively the antenna converts input power into radio waves in a specified direction, compared to a reference antenna (e.g. isotropic or dipole).
**Frequency Response:** performance across a range of frequencies to ensure it operates effectively in the desired frequency band.
**Efficiency:** Typically, the system probe is controlled to move along the z-axis *inter alia,* even though the antenna elements are arranged in a matrix on the antenna's x-y surface, because, as explained above, there are two different measurements, the first being closer to the surface than the other.

Typically, for each frequency a different z plane is employed.

Close surface measurements typically include loading the mechanical x, y position of each element (in the antenna x, y map e.g.).

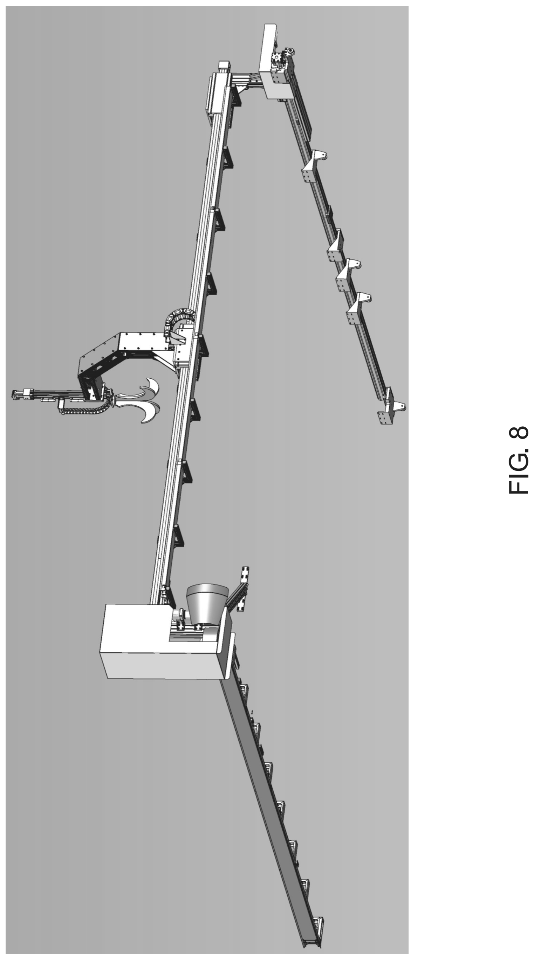

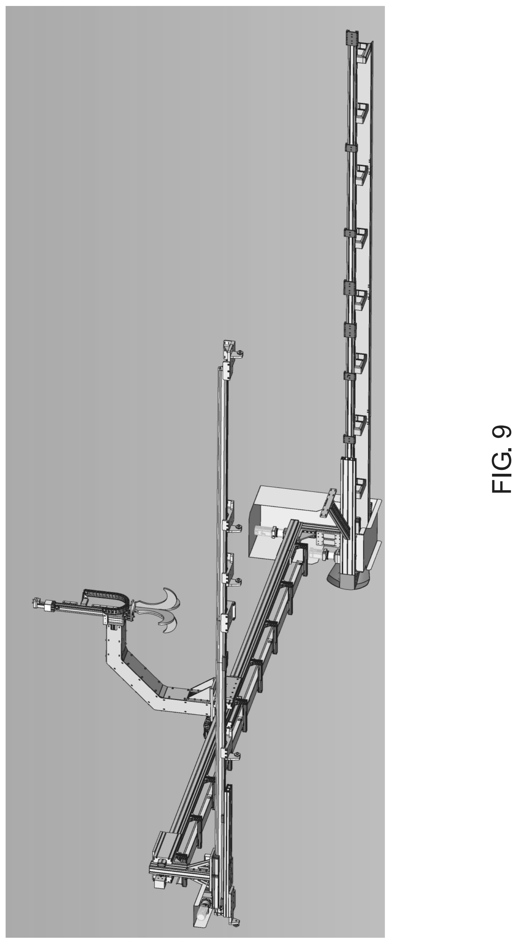

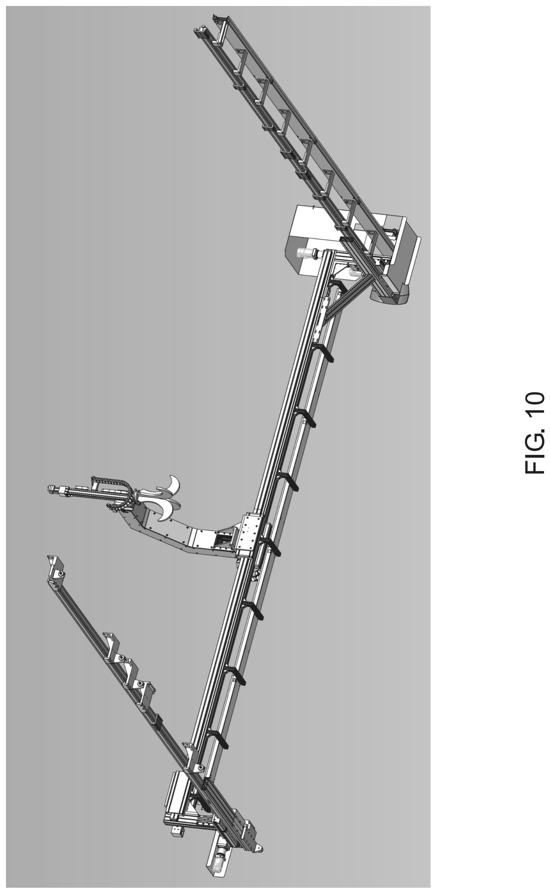

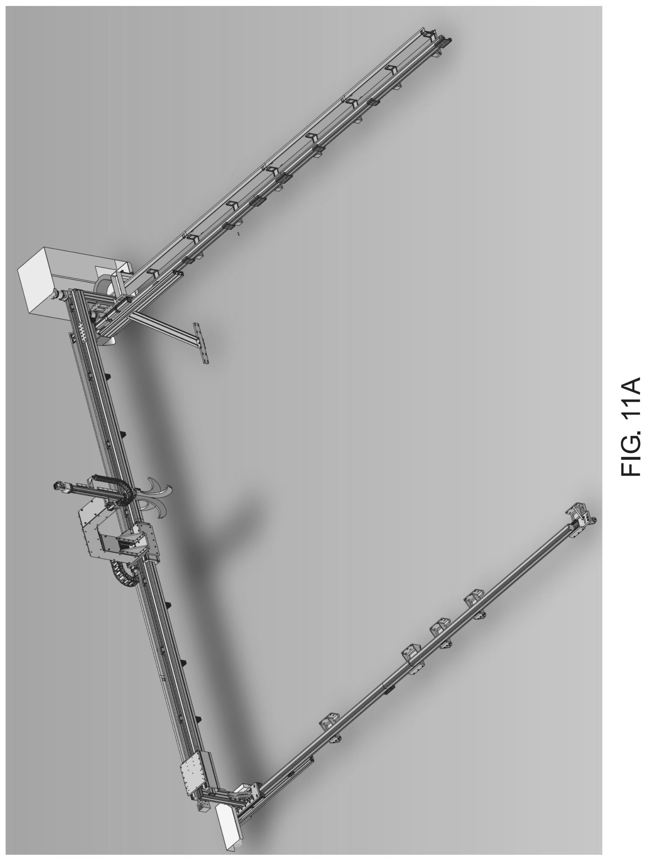

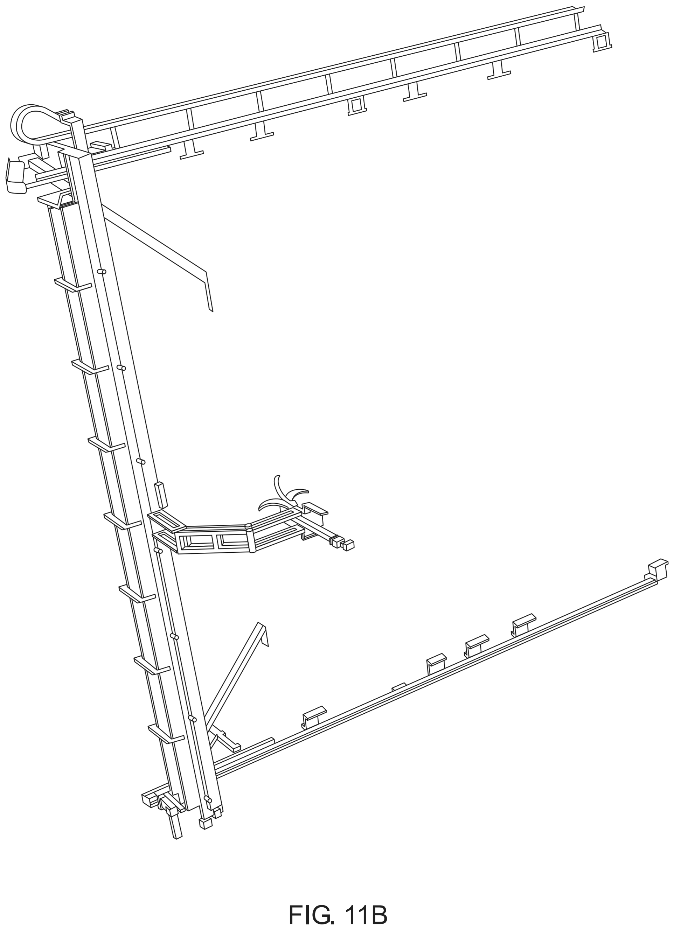

An embodiment of the motorized probe 210 is shown in Figs. 8 to 11b from different perspectives, together with an embodiment of the rails.

The motorized probe 210 controlled by the MCS software may be positioned in front of each element defined by the user, and may measure amplitude and phase using the main antenna RF generator 300 and the sampling computer 310 for analyzing. This provides the user reference for the inside calibration network allowing the user to, in future, replace any malfunctioning unit in the receive chain with a functioning unit, and still calibrate the antenna to equal phase.

Near-field measurement typically includes, inter alia, moving the probe 210 in the z-axis until the probe is, say, more than 3 λ away from the antenna surface 320 where λ is a wavelength of the specific frequency band of the radar. This may be correlated to the measured frequency per each antenna. For example, if an S band is around 3.3Ghz, the wavelength may be around 9cm (3 times is 27cm).

Near-field measurement may include covering or scanning the entire area of the antenna radiated surface in x, y, measuring RF amplitude and phase and at least one probe position,
thereby to yield an energy map.

It is appreciated that typically, two measurements take place, one very close to e.g. a few cm from the surface for calibration ratio extraction and another which may be more then 3 λ away from the surface for near field measurement.

Motion in the z-axis may be achieved using a typically screw-driven, typically modular. typically linear actuator (such as, say, EGT 60 distributed by Nookindustries.com).

According to certain embodiments, position determination may comprise determining antenna element positions using a two-dimensional Fourier series.

Fourier transform is an example method for transitioning from near field to far field by computationally relating the spatial distribution of electromagnetic fields in the near field to their representation in the far field, then using spatial frequency to analyze the fields, including computing far-field patterns based on near-field measurements.

Near field measurements to assess electromagnetic fields (field strength e.g.) and/or radiation patterns proximal to antennas, according to any embodiment herein, typically for a frequency range of interest, may, instead of or in addition to any operations herein, (also) include all or any subset of the following operations, suitably ordered e.g. as follows:
Conventional Measurement Equipment e.g. field strength meters, spectrum analyzers, near-field probes (electric and magnetic), data acquisition systems may be employed.

Typically, a testing location aka measurement area is found which reduces or minimizes interference (e.g. relative to other locations which may be closer to large metal objects and/or to electronic devices).

Set up the antenna under test e.g. by positioning the antenna in the center of the measurement area. Orient antenna as per measurement plan. Place near-field probes at suitable distances and angles from the antenna under test. Secure probes to measurement equipment. Scan e.g. by moving probes systematically in a grid pattern around the antenna under test, measuring or recording field strength data (e.g. as per suitable measurement standards such as FCC or IEC) at specified e.g. equal intervals. Use software tools, e.g., dedicated software, for controlling the probe movements and measurement and also to perform measurements quality test, and to execute near field to far field transformation.

To analyze collected data create visual representations (e.g. contour plots) to interpret or represent near field distribution. Generate recommendations for further testing if/as required by findings. Measurements may be validated with an alternative method known in the art, or tests may be repeated to confirm consistency.

An example probe may have any/all of these characteristics:
- A frequency probe can be replaced according to the required frequency range:
   * Allows movement in three axes as required with an accuracy of 1mm;
   * A mobile calibration system that is mounted on top of the antenna whose dimensions may be say x-axis - 30 meters, y-axis - 6 meters.
   Alternatively, the x and y and or z dimensions may be any size (given that the system is typically scalable).
- z-axis - 53 cm
   - Controlled by the MCS software, opening in Alta instead of the Midas software, which allows:
      - Selecting the scan area
         - Choosing a work mode
      - Selecting a scan frequency
      - Seeing the scan results while working
      - Performing a phase center
- x-axis - top
- Installed along the entire length of the antenna (30 meters) and is behind the radiating surface
- Consists of 5 sections of 6 m length each
- Held by dedicated machined grippers
- x-axis - bottom
- Consists of 5 sections of 6 m length each
- Held by dedicated machined grippers
- Installed along the entire length of the antenna (30 meters) and is behind the radiating surface x-axis - drive
- The x-axis moves the y-axis across the antenna
- The x-axis is driven by two motors working in synchronization
- Rack & Pinion drive
- In the upper part of the x-axis, the cable guide is connected y-axis - drive • The y-axis moves the z-axis along the antenna
- y-axis is driven by a single motor
- Belt drive
- z-axis
- The z-axis allows the probe to move towards the radiating surface
- Screw drive

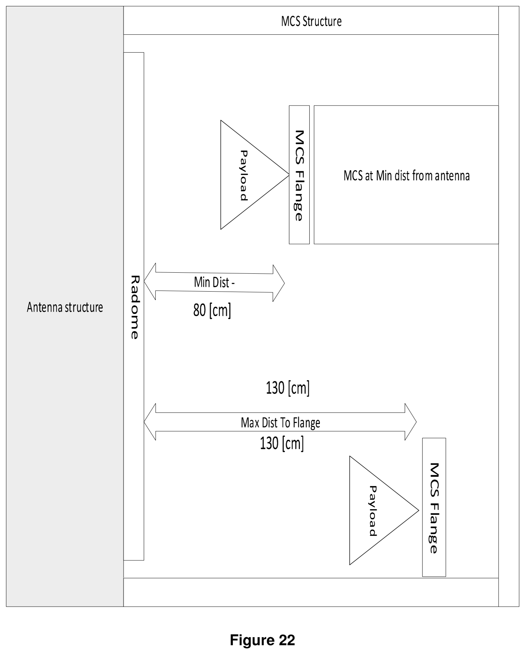

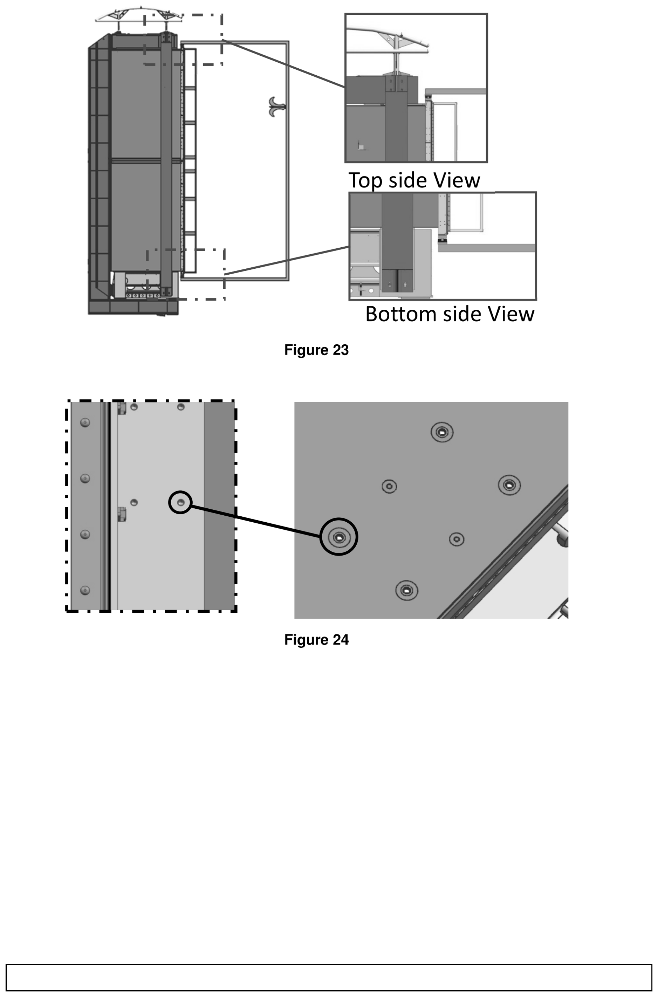

An example method of operation may include all or any subset of the following operations and specifications:
The MCS, a scanning system in three axes, is used to measure, say, an antenna calibration ratio. The structure of the MCS will be installed or mounted on the to be measured antenna. The MCS may interface to the measured antenna. Interface points for the structure may, for example, include RIVNUT type NAS1330C3KB266, screwing 10-32UNF. Typically, the same interface points are located at the top side of the structure and also at the bottom side, e.g. as shown in Fig. 23. The MCS may move on the antenna surface and reach x, y, z positions to be determined in the software during the measurement. For example, x-axis scans a length of 30 meters, y-axis scans a height of 6 meters, and z-axis travels 0.5 meters. By way of example, the distance of the MCS adapter flange from the antenna radome may be 0.8 meters at the furthest point, z-Axis travel may be 0.5 meters, e.g. as shown in Fig. 22.

The scope of the invention is intended to include any MCS system for scanning an antenna, having all or any subset of the following characteristics:
- An MCS may contain an independent rigid mechanical structure, assembled on the measured antenna. Typically, grounding may be according to MIL-STD-464A and MIL-STD-188-124B requirements.
- Due to floating of the DC electrical systems, the DC power returns may not use the structure (chassis) as the return path. A separate return conductor/path may be used.
- Quick and simple installation in the customer's country e.g. an MCS may be disassembled and reassembled at the customer's site in a relatively short time. All assembly parts may be lifted manually (without a crane, but using a lifting platform). All assembly parts and sub-units may not exceed 15 kg (lifting is performed by a maximum of two persons). After reassembly, the system will automatically calibrate itself relative to the measured antenna, with minimal intervention of assembly crews. Complex connection of many parts should be avoided.

- All fasteners (nuts, screws, etc.) may be of the type of NAS/MS.
- Movement of the motors will be performed by a controller when a mapping file x, y, z, is obtained from external software that will be used as an input parameter to the controller software.
- Due to the length of the measured antenna (see Fig. 1), the MCS may be composed of several segments.
- The segments may be connected to the structure using mechanical adapters, such as but not limited to the particular adapters shown and described herein, e.g., with reference to Fig. 14.
- Due to division into several segments there may be calibration of the MCS movements during installation in order to reach the required accuracies.
- The movements may be performed by servo motors which will be mounted on the axis, including an encoder that presents the position of the measurement system at any given moment.
- y-axis movements may be located on x-axis via a motorized shaft through a drive belt or similar, in a controlled manner e.g. using an encoder along the entire y-axis.
- z-axis movements may be located on y-axis via a motorized shaft capable of displacing of, say, overall 1 meter, depending on the length of the antenna in the z dimension.

The scope of the invention is also intended to include any antenna near field measurements method comprising all or any subset of the following operations suitably ordered e.g. as shown in Fig. 5: providing tracks which typically removably engage e.g. clip onto the antenna; moving a probe along the tracks; and providing software which derives calibration data characterizing the antenna using the probe, wherein, typically, as the probe moves, the probe covers the antenna's entire surface.

It is appreciated that terminology such as "mandatory", "required", "need" and "must" refer to implementation choices made within the context of a particular implementation or application described herewithin for clarity, and are not intended to be limiting, since, in an alternative implementation, the same elements might be defined as not mandatory and not required, or might even be eliminated altogether.

Components described herein as software may, alternatively, be implemented wholly or partly in hardware and/or firmware, if desired, using conventional techniques, and vice-versa. Each module or component or processor may be centralized in a single physical location or physical device or distributed over several physical locations or physical devices.

Included in the scope of the present disclosure, inter alia, are electromagnetic signals in accordance with the description herein. These may carry computer-readable instructions for performing any or all of the operations of any of the methods shown and described herein, in any suitable order including simultaneous performance of suitable groups of operations, as appropriate. Included in the scope of the present disclosure, inter alia, are machine-readable instructions for performing any or all of the operations of any of the methods shown and described herein, in any suitable order; program storage devices readable by machine, tangibly embodying a program of instructions executable by the machine to perform any or all of the operations of any of the methods shown and described herein, in any suitable order i.e. not necessarily as shown, including performing various operations in parallel or concurrently rather than sequentially as shown; a computer program product comprising a computer useable medium having computer readable program code, such as executable code, having embodied therein, and/or including computer readable program code for performing, any or all of the operations of any of the methods shown and described herein, in any suitable order; any technical effects brought about by any or all of the operations of any of the methods shown and described herein, when performed in any suitable order; any suitable apparatus or device or combination of such, programmed to perform, alone or in combination, any or all of the operations of any of the methods shown and described herein, in any suitable order; electronic devices, each including at least one processor and/or cooperating input device and/or output device and operative to perform, e.g. in software, any operations shown and described herein; information storage devices or physical records, such as disks or hard drives, causing at least one computer or other device to be configured so as to carry out any or all of the operations of any of the methods shown and described herein, in any suitable order; at least one program pre-stored e.g. in memory or on an information network such as the Internet, before or after being downloaded, which embodies any or all of the operations of any of the methods shown and described herein, in any suitable order, and the method of uploading or downloading such, and a system including server/s and/or client/s for using such; at least one processor configured to perform any combination of the described operations or to execute any combination of the described modules; and hardware which performs any or all of the operations of any of the methods shown and described herein, in any suitable order, either alone or in conjunction with software. Any computer-readable or machine-readable media described herein is intended to include non-transitory computer- or machine-readable media.

Any computations or other forms of analysis described herein may be performed by a suitable computerized method. Any operation or functionality described herein may be wholly or partially computer-implemented, e.g. by one or more processors. The invention shown and described herein may include (a) using a computerized method to identify a solution to any of the problems or for any of the objectives described herein, the solution optionally including at least one of a decision, an action, a product, a service, or any other information described herein, that impacts, in a positive manner, a problem or objectives described herein; and (b) outputting the solution.

The system may, if desired, be implemented as a web-based system employing software, computers, routers, and telecommunications equipment, as appropriate.

Any suitable deployment may be employed to provide functionalities, e.g. software functionalities, shown and described herein. For example, a server may store certain applications, for download to clients, which are executed at the client side, the server side serving only as a storehouse. Any or all functionalities, e.g. software functionalities shown and described herein, may be deployed in a cloud environment. Clients, e.g. mobile communication devices such as smartphones, may be operatively associated with, but external to the cloud.

The scope of the present invention is not limited to structures and functions specifically described herein and is also intended to include devices which have the capacity to yield a structure, or perform a function, described herein, such that even though users of the device may not use the capacity, they are, if they so desire, able to modify the device to obtain the structure or function.

Any "if -then" logic described herein is intended to include embodiments in which a processor is programmed to repeatedly determine whether condition x, which is sometimes true and sometimes false, is currently true or false, and to perform y each time x is determined to be true, thereby to yield a processor which performs y at least once, typically on an "if and only if" basis, e.g. triggered only by determinations that x is true, and never by determinations that x is false.

Any determination of a state or condition described herein, and/or other data generated herein, may be harnessed for any suitable technical effect. For example, the determination may be transmitted or fed to any suitable hardware, firmware or software module, which is known or which is described herein, to have capabilities to perform a technical operation responsive to the state or condition. The technical operation may, for example, comprise changing the state or condition, or may more generally cause any outcome which is technically advantageous, given the state or condition or data, and/or may prevent at least one outcome which is disadvantageous, given the state or condition or data. Alternatively, or in addition, an alert may be provided to an appropriate human operator, or to an appropriate external system.

Applicability of the subject matter disclosed herein is not limited to embodiments claimed, nor to solutions for specific disadvantages emphasized herein, nor need any element of any system and method described herein, on its own or in combination with other elements described herein, operate only in environments or use-cases or technology areas such as those described herein.

Features of the present invention, including operations, which are described in the context of separate embodiments, may also be provided in combination in a single embodiment. For example, a system embodiment is intended to include a corresponding process embodiment, and vice versa. Also, each system embodiment is intended to include a server-centered "view" or client centered "view", or "view" from any other node of the system, of the entire functionality of the system, computer-readable medium, apparatus, including only those functionalities performed at that server or client or node.

Features may also be combined with features known in the art, and particularly, although not limited to, those described in the Background section or in publications mentioned therein.

Conversely, features of the invention, including operations, which are described for brevity in the context of a single embodiment or in a certain order, may be provided separately or in any suitable sub-combination, including with features known in the art (particularly although not limited to those described in the Background section or in publications mentioned therein) or in a different order. "e.g." is used herein in the sense of a specific example which is not intended to be limiting. Each method may comprise all or any subset of the operations illustrated or described, suitably ordered e.g. as illustrated or described herein.

Devices, apparatus, or systems shown coupled in any of the drawings may in fact be integrated into a single platform in certain embodiments, or may be coupled via any appropriate wired or wireless coupling, such as but not limited to optical fiber, Ethernet, Wireless LAN, HomePNA, power line communication, cell phone, Smart Phone (e.g. iPhone), Tablet, Laptop, PDA, Blackberry GPRS, Satellite including GPS, or other mobile delivery. It is appreciated that in the description and drawings shown and described herein, functionalities described or illustrated as systems and sub-units thereof, can also be provided as methods and operations therewithin, and functionalities described or illustrated as methods and operations therewithin can also be provided as systems and sub-units thereof. The scale used to illustrate various elements in the drawings is merely exemplary and/or appropriate for clarity of presentation, and is not intended to be limiting.

## Claims

1. An antenna measurement system comprising:
tracks which typically removably engage e.g. clip onto the antenna, e.g. along at least one axis thereof;
a probe which moves along the tracks; and
software which derives calibration data characterizing the antenna using the probe, wherein, as the probe moves, the probe covers the antenna's entire surface.

2. A system according to claim 1, wherein the probe moves along at least two axes.

3. A system according to claim 1, wherein the probe moves along three axes.

4. A system according to claim 1, wherein the measured data comprises a calibration ratio of the antenna.

5. A system according to claim 1, wherein the tracks comprise plural track segments of a single length to enable the system to accommodate antennas which have different lengths by selecting an appropriate number of the plural track segments to equal or exceed a length of each antenna which the system seeks to calibrate.

6. A system according to claim 1, wherein the probe is controlled by a controller to move along the tracks to cover an entire surface of any antenna sought to be calibrated.

7. A system according to claim 1, also comprising an antenna to be calibrated, wherein the antenna comprises a phased array antenna.

8. A system according to claim 7, wherein the antenna comprises a component in a radar system.

9. A system according to claim 1, wherein the probe which moves along the track comprises any one of plural probes having respective plural frequencies, thereby facilitating near field measurements of plural antennas, each having a different frequency.

10. A system according to claim 1, wherein all components of the system are portable.

11. A system according to claim 1 wherein the tracks are deployed along at least one of two main axes defined by the antenna's main surface.

12. A system according to claim 5, wherein
the plural track segments comprise plural identical track components, each of which typically removably engages the antenna; and/or
the plural track segments each comprise a profile having a uniform cross section.

13. A system according to claim 11 wherein the antenna to be measured has a side-facing main surface, and wherein the tracks are deployed along the antenna's top surface, thereby scanning a horizontal main axis x defined by the antenna's main surface, and wherein a pole is deployed alongside the antenna's side surface, and the probe translates along the pole, thereby to scan the vertical main axis y defined by the antenna's main surface.

14. An antenna near field measurements method comprising:
providing tracks which typically removably engage e.g. clip onto the antenna;
moving a probe along the tracks; and
providing software which derives antenna data characterizing from the probe measurements , wherein, as the probe moves, the probe covers the antenna's entire surface.

15. A method according to claim 14, wherein
the antenna is outdoors, and need not be inside an indoor test range; and/or
the antenna to be measured is an operating antenna remote from a facility responsible for near field measurements , and the antenna is measured *in situ* without being brought to the facility; and/or
said measured data is used for fault finding; and/or
said measured data comprises near field measurements; and/or
said measured data comprises at least one calibration ratio.
